(19) **Europäisches Patentamt**

**European Patent Office**

**Office européen des brevets**

(11) **EP 1 312 926 A1**

(12) **EUROPEAN PATENT APPLICATION**

(43) Date of publication:
21.05.2003 Bulletin 2003/21

(51) Int Cl.⁷: **G01R 19/155**, G01R 13/40

(21) Application number: **01811117.9**

(22) Date of filing: **20.11.2001**

(84) Designated Contracting States:
**AT BE CH CY DE DK ES FI FR GB GR IE IT LI LU
MC NL PT SE TR**
Designated Extension States:
**AL LT LV MK RO SI**

(71) Applicant: **ABB RESEARCH LTD.**
**8050 Zürich (CH)**

(72) Inventors:
• **Strümpfler, Ralf, Dr.**
**5412 Gebenstorf (CH)**
• **Glatz-Reichenbach, Joachim, Dr.**
**5400 Baden (CH)**

(74) Representative: **ABB Patent Attorneys**
**c/o ABB Schweiz AG**
**Brown Boveri Strasse 6**
**5400 Baden (CH)**

(54) **Binary voltage indicator**

(57) The invention is concerned with a binary voltage indicator for use with high- or medium voltage equipment. The indicator comprises a photoactive layer (5) which changes its reflectivity or emissivity when subjected to an electric field and which is applied directly onto the surface of a conductor. The photoactive layer is based on materials as used for low-voltage displays, such as electrophoretic films.

Fig. 1b

EP 1 312 926 A1

## Description

FIELD OF THE INVENTION

The invention relates to the field of high or medium voltage transmission/distribution systems and in particular to a binary voltage indicator for indicating the presence or absence of a voltage applied to a conductor of said system.

STATE OF THE ART

In high voltage (HV) and medium voltage (MV) systems a lot of precautions are necessary in order to avoid touching of the high voltage. As an indication that a line is under voltage one uses either stationary voltage transformers in combination with display electronics or non-stationary voltage indicators. They consist of a high-ohmic resistor and a neon indicator for MV or a capacitive voltage devider in combination with some electronics for HV. In the cases of stationary or non-stationary HV detectors one has to rely on some electronics for the display and has to protect the low voltage equipment from HV-impact or particularly when one has to touch the HV line as in the case of non-stationary detectors.

For low voltage displays electrophoretic films have been proposed. They consist of microcapsules, filled with a suspension of coloured particles and a dielectric fluid, which are embedded in a binder between at least two electrodes. At an applied field of 2.36 kV/mm and 1 Hz a contrast (maximum minus minimum reflected optical power) of 8 is achieved. At 50 Hz it is still about 3 for the same field (B. Comiskey, J. D. Albert, H. Yoshizawa, and J. Jacobson, "An Electrophoretic Ink for All-Printed Reflective Electronic Displays," Nature 394, No. 6690, 253-255, July 16, 1998).

The Gyrion Rotating Ball Display from Xerox is a flat device, which is able to switch between black and white surface colour when applying a sufficiently high electrical field (190 - 1250 V/mm). The device is of composite structure with black and white hemisphere ball spheres, dispersed into a silicon rubber sheet and able to rotate. The size of the bichromal ball spheres is between 25 and 100 $\mu$m. (M. E. Howard, E. A. Richley, R. Spraque, N. K. Sheridon "Gyricon Electric Paper" 1998 SID Int. Symp. Digest of Technical Papers Society for Information Display, Vol. 29 1010-13, 1998)

Also liquid display devices (LCD) are widely used as electronic displays which bases on a well established technique to indicate two dimensional structures by applying low voltage (e.g. 4 V across 6 $\mu$m). At present a strong interest rises to exchange LCD by organic light emitting diodes (OLED) or to use OLED as backlight for LCD screens with the advantage to have an all-organic device with much improved luminous intensities. LCDs are emitting with a luminosity in the range of 1.5 1m/W whereas e.g. PolyLED from Philips reaches 4-5 times higher value. (Dino A. Pardo, Ghassan E. Jabbour and Nasser Peyghambarian, Application of Screen Printing in the Fabrication of Organic Light-Emitting Devices, Adv. Mater.12 (17) 1249-52, 2000)

DESCRIPTION OF THE INVENTION

It is therefore an object of the present invention to create a reliable, simple and safe visual indication if a power line is set on voltage or not. These objects are achieved by a binary voltage indicator according to claim 1. Preferred embodiments are evident from the dependent patent claims.

The basic idea is to use the electric field, which exists near the surface of every conductor to which a voltage is applied, to let a thin photoactive layer of the type known from the low voltage displays mentioned above and which is coated onto the conductor either reflect light or emit light in order to warn that voltage is applied. As was realised in the context of the present invention, no second (counter-)electrode in contact with the photoactive layer is needed to make the latter work. Instead, the second electrode is placed at a certain distance from the conductor and the geometry is chosen such that the electric field in the vicinity of the photoactive layer (which is due to the voltage difference between the conductor and the second electrode) is sufficient.

Furthermore, the indicator operates not only with time-constant electric fields such as e.g. the ones associated with High-Voltage DC transmission systems, but equally well with AC-fields oscillating at line frequency, preferably in the medium voltage range of 10 - 24 kV or the high voltage range of 70 - 750 kV. In this case, the second electrode may be one of the other two conductors of a three phase electricity transmission or distribution system.

The photoactive layer preferentially forms words such as "caution", warning the public of the potential being applied to the conductor. What is perceived as a disadvantage in the context of low voltage displays, i.e. the non-persistentness or fading-away of a message once the potential is switched off, turns into a useful feature in the context of voltage indicators. On the other hand, words such as "grounded" indicating the absence of the voltage, may be surrounded by a background of the same reflectivity or colour as the photoactiv layer when under tension. This way, the word or message is readable as long as there is no voltage being applied to the conductor.

An estimation of the electric field on the surface of a conductor line proves the feasibility of the proposed concept. For a cylindrical geometry, said electric field on the conductor surface is given by:

$$E = E = \lambda/(2\pi\varepsilon_0 r),$$

where $\lambda$ is the charge on the conductor per length, $\varepsilon_0$ is the electrical permittivity and r the radius of the conductor. The potential on the conductor surface is yielded by integration:

$$V = \lambda \ \ln \ (R/r) \ / \ (2 \ \pi \ \varepsilon_0),$$

where R is the assumed distance in which the (ground) potential is located towards which the voltage of the conductor is applied. Eliminating $\lambda$, the electric field E becomes:

$$E = V \ / \ (r \ \ln \ (R/r)).$$

For a conductor radius of 0.5 cm, a distance to ground of 15 cm and a voltage of 15 kV, the electric field on the conductor surface becomes E = 882 V/mm. For r = 1 cm, R = 30 cm and a voltage of 36 kV a field of 1.06 kV/mm exists on the conductor surface. For a conductor radius of 5 cm, a distance to ground of 400 cm and a voltage of 400 kV: E = 1.82 kV/mm. Electrophoretic layers as the ones mentioned initially start giving a good contrast at 1 kV/mm.

BRIEF DESCRIPTION OF THE DRAWINGS

The subject matter of the invention will be explained in more detail in the following text with reference to preferred exemplary embodiments which are illustrated in the attached schematical drawings, in which:

> Fig. 1 shows the effect of voltage indicator as used in a substation;
> Fig.2, Fig.3 and Fig.4 show a cross section through a voltage indicator according to preferred embodiments of the invention.

The reference symbols used in the drawings, and their meanings, are listed in summary form in the list of reference symbols. In principle, identical parts are provided with the same reference symbols in the figures.

DETAILED DESCRIPTION OF PREFERRED EMBODIMENTS

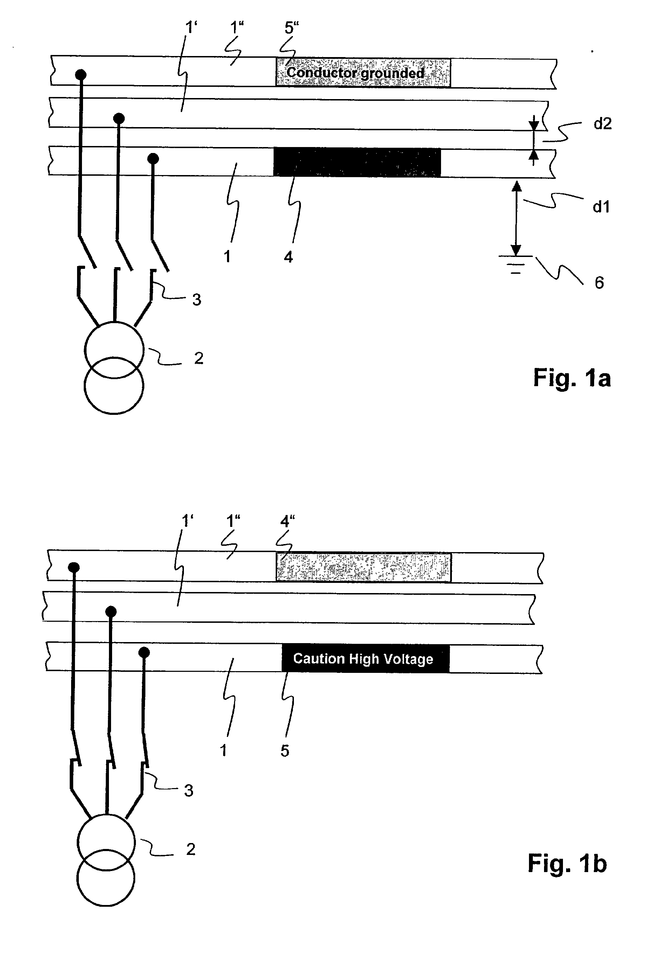

Fig.1 shows a possible application of a voltage indicator according to the invention in a MV substation. High voltage can be applied to the three-phase conductor bars 1,1',1" via a transformer 2 and MV switches 3. A first conductor bar 1 is painted with a background layer 4 on or next to which are printed letters consisting of a photoactive layer 5. The background layer 4 has the same colour as the photoactive layer 5 when no electric field is present (fig.1a). When the switches are closed (fig.1b) an electric field influences the reflectivity or the emissivity of the photoactive layer 5 and the printed letters appear against the background layer 4. Said electric field is due to the voltage drop between the conductor 1 at MV or HV potential and either another conductor 1' or ground potential 6. The second conductor 1' or the ground potential 6, which are at a distance d1 or d2 respectively from the first conductor 1, serve as second electrodes for the photoactive layer 5.

Alternatively, a third conductor 1" is painted with a background layer 4" which has the same colour as the photoactive layer 5"under the influence of an electric field (fig.1b). In this case, the letters appear when no voltage is applied to the conductor (fig.1a).

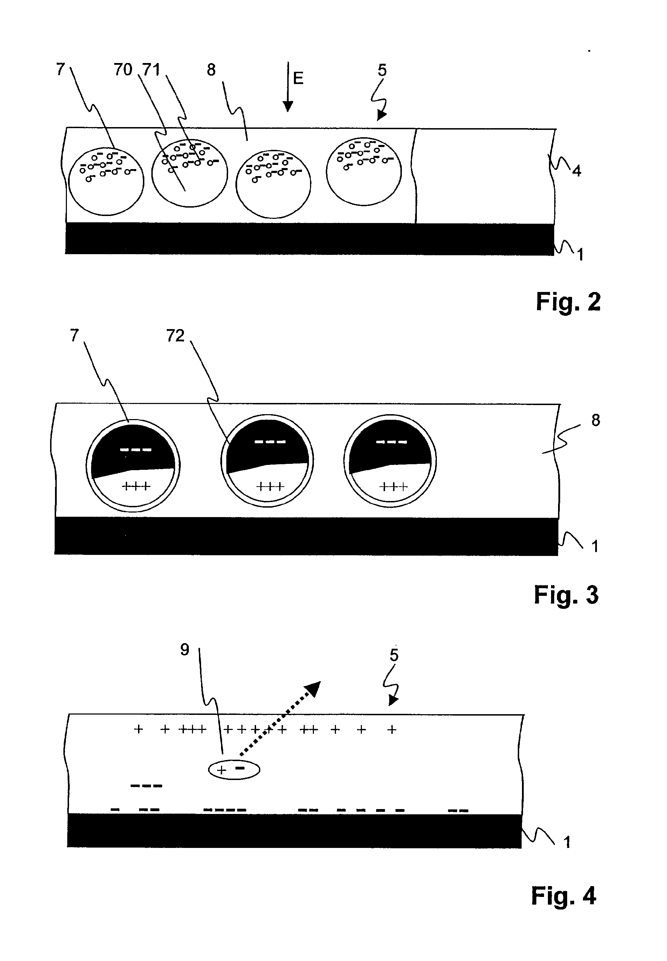

Fig.2 shows the principle configuration of a voltage indicator using an electrophoretic film as a photoactive layer 5. The film 5 consists of hollow microcapsules 7 which are dispersed in a matrix 8, i.e. a binder or lacquer, and brought onto the conductor 1. The areas containing microcapsules 7 are e.g. printed as letters next to background layers 4 or areas of binder, which are coloured with a dye in such a way that it has a colour as the non-oriented electrophoretic layer. The capsules 7 contain a dielectric fluid 70 and a suspension of visually contrasting particles 71, which carry a charge. The electric field of the conductor causes an orientation and migration of the coloured particles 71 within the capsules 7. This results in a change in colour/brightness when one is looking onto the film. Alternatively the capsules 7 can contain a suspension of dielectric particles 71 in a visually contrasting fluid 70. When an electric field is applied the particles orient in chains along the directions of the electric field. This causes a colour change when the film is viewed from the top.

The microcapsules have a typical size of 1 - 100 μm, preferred 2 - 30 μm whereas the particles have diameters of 0.1- 5 μm, preferably 0.5 - 1.5 μm. With 0.5 μm they can travel even at fields as low as 2 kV/mm with a velocity of 400 μm/s. In microcapsules of 4 μm diameter the particles can then move at 50 Hz within the capsule from one wall to the other and back again. Hence, for 1 kV/mm (e.g. 36 kV line, 1 cm conductor radius, 30 cm ground distance), the micro capsules are preferably not larger than 2 μm in order to allow the particles to traverse a round trip.

The particles can either carry a native charge or are being charged by the help of a charge-control agent. Useful materials are $TiO_2$ ZnO, $SnO_2$ which are inexpensive and have a white colour. For black particles carbon black might be used. The charge-control agent confers a zeta potential on the surface of the particles and can be a polymer as polyethylene, polybutene succinimide or a polyvinyl pyridine block co-polymer. The particle can be either composites of the anorganic ($TiO_2$) and organic material as made in an atomizer or anorganic particles with an outer polymer coating, which can be prepared e.g. by ball milling or chemical means. The density of the particles is preferably similar to the density of the dielectric fluid in the microcapsule into which the particles a suspended. This can be a darkly coloured hydrophobic fluid as light oil, isoparaffinic petroleum solvent or an aliphatic hydrocarbon or tetrachloroethylene.

The formation of the microcapsules is performed out of an emulsion of the oil (or other hydrophobic liquid) in water. The particles are then contained in the oil droplets. Capsules are formed around the oil droplets by processes known as coacervation, an interfacial polymerization, or in-situ polymerization using e. g. an urea /formaldehyde condensation process in the presence of poly(acrylic acid). The microcapsules are finally dispersed in a binder, which should be transparent and perhaps curable. Examples are epoxies, polyvinyl alcohols, gelatins or other resins.

Fig.3 shows the principle configuration of a voltage indicator, which uses as the optical indicator the Gyrion Rotating Ball Display Material. Small bicoloured spheres 72 are embedded into a second, fluid filled sphere 7 and are able to rotate due to the interaction of their dipolar momentum with the electrical field E and to orient along the latter. In the case that same coloured hemispheres are charged to the same polarity, a strong optical contrast can be expected for such field-oriented particles. The double spheres 7,72 are finally incorporated into a matrix 8, for example a clear resin, which can be also coloured by pigments for contrast reasons. The micro-spheres 7 have a typical size of 25 - 100 µm.

Especially when one type of hemisphere is more attracted to the conductor e.g. by physisorption or chemisorption effect, (which may have its origin in the nature of the particle surface), this hemisphere is likely to stick to the conductor, and even at AC-electrical fields a strong optical contrast should be given.

Fig.4 shows the principle configuration of a voltage indicator, which uses a light emitting layer 5 as the optical indicator. The light is created at the recombination centre 9 where injected positive and negative charge carriers are recombining under emission of visible light. For a structured application of the light emitting layer 5 onto the conductor 1, e.g. as letters or signs, these patterns start to light when an electrical field of sufficient strength is applied.

As one suitable material the active layer material of organic light emitting diodes (OLED) can be used. Such materials can consist of small organic molecules or of a polymer suitable to be applied to the metal surface by physical vapour deposition (PVD) for small molecules or by spin coating or solution casting technique for polymers. In this way both film surfaces, the one adjacent to the HV-conductor and the one exposed to air or inert gas (e.g. N2 or SF6) side act as charge carrier injection regions under electrical field exposure. The organic layer in between is the recombination centre where the light is generated and emitted.

As an active light emitting material can be used e.g. green light emitting polyphenylene vinylene (PPV) from Cambridge Device Technology. Other organic light emitting materials are e.g. N,N'-diphenyl-N,N'-bis(3-methylphenyl)-(1,1'-biphenyl)-4,4'-diamine (i.e. TPD) or 8-tris-hydroxyquinoline aluminium (i.e. Alq3) or poly-(2-mothoxy-5-(2'-ethylhexyloxy)-1,4-phenylenevinylene (i.e. MEH-PPV). The active light emitting layers are about 60 nm to 200 nm in thickness and can be driven to emit light by voltages from 3 to 16 V which corresponds to electrical field strength of 15 - 266 kV/mm.

LIST OF DESIGNATIONS

| | |
|---|---|
| 1,1',1" | conductor |
| 2 | transformer |
| 3 | switch |
| 4,4" | background layer |
| 5,5" | photoactive layer |
| 6 | ground potential |
| 7 | microcapsules |
| 70 | fluid |
| 71 | coloured particles |
| 72 | bicoloured spheres |
| 8 | matrix |
| 9 | recombination centre |

**Claims**

1. A binary voltage indicator comprising
   a first electrode as part of a first conductor (1), wherein a first voltage (U1) can be applied to said first conductor (1),
   a second electrode, arranged at a distance (d) from the first electrode,
   a photoactive layer (5) attached to the first conductor (1) and consisting of a light-emitting or light-absorbing material which changes its emissivity or reflectivity under the influence of an electric field (E1) generated by the first voltage (U1).

2. The voltage indicator as claimed in claim 1, **characterized in that** the first voltage (U1) is an alternating voltage in the medium or high voltage range at line frequency.

3. The voltage indicator as claimed in claim 2, **characterized in that** the second electrode is part of a second conductor (1') of a three phase electricity transmission or distribution system.

4. The voltage indicator as claimed in claim 1, **characterized in that** the second electrode is on ground potential (6).

5. The voltage indicator as claimed in claim 1, **characterized in that** a gap between the photoactive layer (5) and the second electrode is filled with air or insulating gas.

6. The voltage indicator as claimed in claim 1, **characterized in that** the light absorbing material of the photoactive layer (5) comprises an electrophoretic material.

7. The voltage indicator as claimed in claim 6, **characterized in that** the electrophoretic material comprises microcapsules (7) containing a plurality of visually contrasting phases (70,71,72) with different responsivenesses to the electric field (E1).

8. The voltage indicator as claimed in claim 1, **characterized in that** the light-emitting material of the photoactive layer (5) is the active material of organic light emitting diodes (OLED).

9. The voltage indicator as claimed in one of the preceeding claims, **characterized in that** the photoactive layer (5) takes the form of letters warning the public of the presence, or indicating to the public the absence, of said first alternating voltage (U1) being applied to the first conductor (10).

10. Use of a photoactive layer (5) consisting of a light-emitting or light-absorbing material which changes its emissivity or reflectivity under the influence of an electric field (E1) as a binary voltage indicator attached to a first conductor (1) between a first electrode which is part of the first conductor (1) and a second electrode arranged at a distance (d) from the first electrode, and indicating the presence or the absence of a voltage (U1) being applied to the first conductor (1).

Fig. 1a

Fig. 1b

Fig. 2

Fig. 3

Fig. 4

**EP 1 312 926 A1**

**European Patent Office**

**EUROPEAN SEARCH REPORT**

Application Number

EP 01 81 1117

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | DE 199 30 835 A (MOELLER) 4 January 2001 (2001-01-04) | 1,10 | G01R19/155 G01R13/40 |
| Y | * column 4, line 27 - line 34 * | 6-9 | |
| X | EP 0 501 609 A (MITSUBISHI) 2 September 1992 (1992-09-02) * column 4, line 47 - column 5, line 7 * * column 5, line 30 - column 6, line 2; figures 7A,7B * | 1,6 | |
| Y | US 2001/055000 A1 (KANAE NORIHIKO ET AL) 27 December 2001 (2001-12-27) * abstract; figure 1 * & WO 01 11424 A (SEIKO EPSON) 15 February 2001 (2001-02-15) | 6,7 | |
| Y | US 6 262 441 B1 (BÖHLER ET AL.) 17 July 2001 (2001-07-17) * abstract; figure 2 * | 8 | |
| Y | US 5 274 324 A (SCHWEITZER) 28 December 1993 (1993-12-28) * abstract; figures 1,2,5 * | 9 | TECHNICAL FIELDS SEARCHED (Int.Cl.7) G01R |
| A | US 5 051 733 A (NEUHOUSER) 24 September 1991 (1991-09-24) * abstract * | 1,10 | |

The present search report has been drawn up for all claims

| Place of search | Date of completion of the search | Examiner |
|---|---|---|
| THE HAGUE | 10 May 2002 | Iwansson, K |

CATEGORY OF CITED DOCUMENTS

X : particularly relevant if taken alone
Y : particularly relevant if combined with another
  document of the same category
A : technological background
O : non-written disclosure
P : intermediate document

T : theory or principle underlying the invention
E : earlier patent document, but published on, or
  after the filing date
D : document cited in the application
L : document cited for other reasons

& : member of the same patent family, corresponding
  document

EPO FORM 1503 03.82 (P04C01)

8

**ANNEX TO THE EUROPEAN SEARCH REPORT
ON EUROPEAN PATENT APPLICATION NO.**                    EP 01 81 1117

This annex lists the patent family members relating to the patent documents cited in the above-mentioned European search report.
The members are as contained in the European Patent Office EDP file on
The European Patent Office is in no way liable for these particulars which are merely given for the purpose of information.

10-05-2002

| Patent document cited in search report | | Publication date | Patent family member(s) | | Publication date |
|---|---|---|---|---|---|
| DE 19930835 | A | 04-01-2001 | DE 19930835 A1 | | 04-01-2001 |
| EP 501609 | A | 02-09-1992 | JP 4262277 A | | 17-09-1992 |
| | | | DE 69211032 D1 | | 04-07-1996 |
| | | | DE 69211032 T2 | | 02-10-1996 |
| | | | EP 0501609 A1 | | 02-09-1992 |
| | | | US 5256500 A | | 26-10-1993 |
| US 2001055000 | A1 | 27-12-2001 | AU 6316500 A | | 05-03-2001 |
| | | | WO 0111424 A1 | | 15-02-2001 |
| US 6262441 | B1 | 17-07-2001 | EP 0966050 A2 | | 22-12-1999 |
| | | | JP 2000030873 A | | 28-01-2000 |
| | | | TW 439301 B | | 07-06-2001 |
| | | | US 2001025956 A1 | | 04-10-2001 |
| US 5274324 | A | 28-12-1993 | CA 2024243 A1 | | 09-05-1991 |
| | | | CA 2028390 A1 | | 09-05-1991 |
| | | | US 5095265 A | | 10-03-1992 |
| US 5051733 | A | 24-09-1991 | NONE | | |

EPO FORM P0459

For more details about this annex : see Official Journal of the European Patent Office, No. 12/82